# EUROPÄISCHE PATENTSCHRIFT

(11) **EP 3 204 783 B1**
(45) Veröffentlichungstag und Bekanntmachung des Hinweises auf die Patenterteilung: **04.11.2020**
(21) Anmeldenummer: 15771936.0
(22) Anmeldetag: 29.09.2015
(51) Int. Cl.: G01R 31/327, G01R 19/25, G01R 1/04

(54) **PRÜFANORDNUNG UND VERFAHREN ZUR PRÜFUNG EINER SCHALTANLAGE**
TEST ARRANGEMENT AND METHOD FOR TESTING A SWITCHING SYSTEM
DISPOSITIF DE TEST ET PROCÉDÉ DE TEST D'UN SYSTÈME DE COMMUTATION

(30) Priorität: 07.10.2014 AT 507162014
(43) Veröffentlichungstag der Anmeldung: 16.08.2017
(73) Patentinhaber: Omicron electronics GmbH, 6833 Klaus (AT)
(72) Erfinder: JOCHUM, Michael, 6844 Altach (AT); GEIGER, Stephan, 6837 Weiler (AT); KÜNG, Rainer, 6741 Raggal (AT)
(74) Vertreter: Patentanwälte Pinter & Weiss OG
(86) Internationale Anmeldenummer: PCT/EP2015/072438
(87) Internationale Veröffentlichungsnummer: WO 2016/055307

(56) Entgegenhaltungen:
- EP-A1- 1 515 411
- EP-A2- 2 273 278
- WO-A1-2011/030190
- DE-A1-102012 004 848
- Anonymous: "Plug and Play - Wikipedia", , 19. April 2014 (2014-04-19), XP055238085, Gefunden im Internet: URL:https://de.wikipedia.org/w/index.php?t itle=Plug_and_Play&oldid=131448252 [gefunden am 2015-12-22]

## Beschreibung

Die gegenständliche Erfindung betrifft ein Prüfgerät und ein damit verbundenes Adapterkabel für eine Steuereinheit einer Schaltvorrichtung einer Schaltanlage, wobei das Prüfgerät eine Anzahl von Signaleingängen und einer Anzahl von Signalausgängen aufweist und das Prüfgerät über das Adapterkabel mit der Steuereinheit verbunden ist und das Prüfgerät für die Prüfung die Schaltvorrichtung nachbildet, eine Verwendung des Prüfgeräts und des Adapterkabels in einer Prüfanordnung und ein zugehöriges Verfahren zur Vorbereitung einer Prüfung einer Schaltanlage.

In Anlagen zur Übertragung oder Verteilung von elektrischer Energie, z.B. ein elektrisches Versorgungsnetz, kommen verschiedene Sicherheitseinrichtungen zum Einsatz. Typische Sicherheitseinrichtungen sind beispielsweise sogenannte Wiedereinschaltvorrichtungen (bekannter unter dem englischen Namen Recloser) oder Trennschalter (bekannter und dem englischen Namen Sectionalizer). Ein Recloser überwacht Strom und Spannung der einzelnen Phasen der elektrischen Anlage, untereinander, aber auch gegenüber Erde oder Nullleiter, und trennt eine oder alle Phasen, wenn ein elektrischer Fehler, z.B. ein hoher Fehlerstrom aufgrund eines Kurzschlusses gegen Erde einer Phase, erkannt wird. Nach einer gewissen, voreingestellten Zeit wird die vorher getrennte Phase wieder zugeschaltet. Liegt der Fehler immer noch an, wiederholt sich das Trennen und Wiederschließen für eine vorgegebene Anzahl von Versuchen. Ein Sectionalizer erfasst typischerweise keinen elektrischen Fehler, sondern trennt eine elektrische Leitung aufgrund anderer Kriterien, z.B. nach einer bestimmten Anzahl von erkannten Wiederschließversuchen eines vorgelagerten Reclosers. Ebenso kommen in elektrischen Anlagen auch elektrische Schalter, wie z.B. Leistungsschalter (auch bekannt als Circuit Breaker) zum Einsatz. Allgemein und im Folgenden werden solche vorgenannten Geräte als Schaltvorrichtungen bezeichnet. Gemein ist solchen Schaltvorrichtungen, dass diese eine Steuereinheit aufweisen, die das Schalten der Schaltvorrichtung anhand von bestimmten Steuereingangsgrößen, typischerweise gemessene Ströme, oft auch zusammen mit gemessenen Spannungen, überwacht und auslöst. Die Schaltvorrichtung wird dabei über Steuerausgangsgrößen der Steuereinheit angesteuert, beispielsweise in Form elektrischer Signale auf einer Steuerleitung.

Um die ordnungsgemäße Funktion einer Steuereinheit einer Schaltvorrichtung sicherzustellen ist vorgesehen, dass diese von Zeit zu Zeit bzw. in regelmäßigen Abständen überprüft wird. Hierzu gibt es entsprechende Prüfgeräte, die über ein Prüfkabel mit der Steuereinheit verbunden werden und die die Funktion der Schaltvorrichtung simulieren, z.B. eine Schalthandlung, die Schalterhilfskontakte eines Leistungsschalters, etc. Die Schaltvorrichtung wird dazu von der Steuereinheit getrennt und durch das Prüfgerät ersetzt, das damit die Schaltvorrichtung nachbildet. Das Problem dabei ist, dass es verschiedenste Hersteller von Schaltvorrichtungen und Steuereinheiten gibt, die noch dazu unterschiedlichste elektrische Schnittstellen zwischen diesen Einheiten, sowohl in der Pinanzahl auch in der Pinbelegung, verwenden. Das bedingt, dass unterschiedliche Adapterkabel für die unterschiedlichen elektrischen Schnittstellen notwendig sind. Es ist daher für die Prüfung erforderlich eine Vielzahl von Adapterkabel vorrätig zu halten, um überhaupt eine Verbindung zwischen Prüfgerät und den verschiedenen Steuereinheiten herstellen zu können. Daneben müssen die Signalein- und Signalausgänge des Prüfgeräts 10, die sowohl analog, als auch digital sein können, in Abhängigkeit von der Schaltvorrichtung und der Steuereinheit parametriert werden, beispielsweise die verwendeten Spannungspegel, das Timing bestimmter Signale, der logische Inhalt einer digitalen 0 oder 1, usw.

Mit einem Signalausgang des Prüfgeräts in Form eines Binärausgangs wird beispielsweise ein Schalterhilfskontakt simuliert (Stellung offen oder geschlossen) und an einem Signaleingang des Prüfgeräts in Form eines Binäreingangs wird beispielsweise ein Schließen/Öffnen-Befehl der Steuereinheit erkannt. Die Signale an den Binäreingängen sind typischerweise Spannungen, die in Abhängigkeit von der zu simulierenden Schaltvorrichtung in der Amplitude variieren. Meist kommt eine DC-Spannung zum Einsatz, die entweder eine Steuerkleinspannung (z.B. 24V) darstellt oder eine Spannung, die von einer großen Kapazität in der Steuereinheit (welche meist eine höhere Spannung liefert, wie z.B. 48V, 155V oder 240V) geliefert wird, um direkt die DC-Spule im Leistungsschalter zu betätigen. Im Falle eines Binäreingangs muss z.B. diesem Signaleingang des Prüfgeräts eine Funktion und ein Anregewert (wie ein Spannungspegel) zugewiesen werden.

Um eine Schaltvorrichtung durch das Prüfgerät simulieren zu können, müssen darüber hinaus auch noch Parameter der Schaltvorrichtung im Prüfgerät parametriert werden, beispielsweise Auslösezeiten, Schließzeiten, Zeitverzögerungen der Hilfskontakte, etc. Beispielsweise liegt ein Signal am Binäreingang üblicherweise weniger als 100ms lang an, entweder als Trip (Öffnen) oder Close (Schließen) Signal. Dieses Trip oder Close Kommando kann ein einzelnes sein für jede Phase (im Falle einer mehrphasigen Schaltvorrichtung), es kann aber auch ein Trip und Close für jede Phase einzeln geben, wenn die Schaltvorrichtung diese Funktionalität besitzt. Aber auch eine zeitliche Sequenz von Zuständen von Signalausgängen des Prüfgeräts in Abhängigkeit von Zustandsänderungen von Signaleingängen kann zu konfigurieren sein. Bisher erfolgte diese notwendige Parametrierung bzw. Konfiguration großteils manuell durch einen Benutzer des Prüfgeräts und der Benutzer musste wissen, was alles einzustellen ist, um eine ordentliche Prüfung der Steuereinheit durchführen zu können. D.h., dass am Prüfgerät eine geeignete I/O-Schnittstelle zu einem Ein-/Ausgabegerät, z.B. ein Laptop, ein Tablet oder eine Bedienungseinheit vorhanden sein muss, um die erforderlichen Parameter eingeben und die notwendigen Einstellungen vornehmen zu können. Zusätzlich muss am Ein-/Ausgabegerät auch geeignete Software installiert sein, um das Prüfgerät entsprechenden den Anforderungen konfigurieren zu können und um die Simulation der Schaltvorrichtung durchführen zu können.

Eine Verbesserung der umständlichen Konfiguration eines Prüfgeräts bietet die DE 10 2012 004 848 A1. Darin wird ein Simulationsgerät mit einem Simulationsmodul beschrieben, wobei im Simulationsmodul eine Firmware installiert werden kann, in der die Schalterlogik und die Schalterfunktion eines zu prüfenden Schalters abgebildet ist. Weiters wird im Simulationsmodul eine Konfiguration abgelegt, die den Typ der Schaltvorrichtung kennzeichnet und eine Adresse zur Identifikation und Zuordnung in der Prüfsoftware festlegt. Das Simulationsgerät wird über ein Steckermodul mit der Schaltanlage verbunden. Die Prüfsoftware zur Funktionsprüfung ist auf einem externen Computer installiert, der mit dem Simulationsmodul über eine drahtlose Verbindung verbunden ist. Damit kann eine komplette Parametrierung und Konfiguration vorbereitet werden und muss nicht mehr manuell vorgenommen werden. Sollen hiermit verschiedene Schaltvorrichtungen und deren Steuereinheit geprüft werden bedarf es aber verschiedener Steckermodule und auch verschieden konfigurierter Simulationsmodule für die verschiedenen Typen von Schaltanlagen, oder es muss für jeden Test zuerst die benötige Firmware auf das Simulationsmodul aufgespielt werden.

Die US 7,259,565 B2 zeigt ein Verfahren zum Testen einer Schaltanlage mit einer Schaltvorrichtung und einer Steuereinheit. Hier sind in der Steuereinheit in einer Speichereinheit die Konfiguration der Schaltanlage und die Testparameter abgespeichert. Ein Prüfgerät kann mit der Steuereinheit verbunden werden und das Prüfgerät liest die Konfiguration und die Testparameter aus der Speichereinheit aus. Das Problem bei dieser Vorgehensweise ist darin zu sehen, dass die Speichereinheit nur mit einem dafür vorgesehenen Prüfgerät auslesbar ist, da die Art und Weise, wie die Konfiguration und die Testparameter im Steuergerät gespeichert sind und wie diese auszulesen sind herstellerspezifisch sind und in der Regel nicht einmal öffentlich dokumentiert sind. Das bedingt wiederum, dass für verschiedene Schaltanlagen und für verschiedene Hersteller eine Vielzahl von verschiedenen, herstellerspezifischen Prüfgeräten vorrätig zu halten wären, was das Prüfen von Schaltanlagen logistisch sehr aufwendig macht.

Die EP 2 273 278 A2 offenbart ein Prüfsystem zum Prüfen einer Leitungsanordnung und weist einen Adapter auf. Im Adapter sind auf einem Speicher Konfigurationsdaten gespeichert, die von einem Prüfgerät ausgelesen und zum Schalten einer Schaltmatrix herangezogen werden können.

Es ist eine Aufgabe der gegenständlichen Erfindung ein Prüfgerät samt Adapterkabel und ein Verfahren anzugeben, mit dem auf einfachste Weise Schaltanlagen von verschiedenen Herstellern und Typen geprüft werden können.

Diese Aufgabe wird erfindungsgemäß dadurch gelöst, dass am Adapterkabel eine Speichereinheit vorgesehen ist, auf der konfigurationsspezifische Daten gespeichert und vom Prüfgerät auslesbar sind und das Prüfgerät ausgebildet ist, seine für eine Durchführung einer Prüfung benötigten Signaleingänge und Signalausgänge gemäß den konfigurationsspezifischen Daten selbsttätig zu konfigurieren. Das erfindungsgemäße Prüfgerät und Adapterkabel können in einer Prüfanordnung zum Prüfen einer Steuereinheit einer Schaltvorrichtung einer Schaltanlage verwendet werden, wobei das Adapterkabel mit der Steuereinheit verbunden ist. Damit wird der Umstand ausgenutzt, dass anhand der Adapterkabel auf die Schaltvorrichtung der Schaltanlage geschlossen werden kann. Werden nun am Adapterkabel konfigurationsspezifische Daten gespeichert, können diese nach Verbinden des Prüfgeräts und der Steuereinheit mit dem Adapterkabel vom Prüfgerät ausgelesen werden. Das ermöglicht es dem Prüfgerät, sich mit diesen konfigurationsspezifischen Daten selbsttätig zu konfigurieren, was den Aufwand für die Durchführung einer Prüfung erheblich reduziert, da für die Vorbereitung kein Eingriff eines Benutzers notwendig ist. Damit lassen sich auch allfällige Fehler beim Vorbereiten der Prüfung vermeiden, da das Adapterkabel nur zu einer bestimmten Kombination von Steuereinheit und Schaltvorrichtung passt, wodurch auch eine falsche Konfiguration des Prüfgeräts praktisch ausgeschlossen ist.

Je nach Ausführung können als konfigurationsspezifische Daten eine eindeutige Identifikation des Adapterkabels gespeichert sein, die es ermöglicht aus einem Konfigurationsdatenspeicher zugeordnete Konfigurationsdaten zur Konfiguration von benötigten Signaleingänge und Signalausgänge auszulesen. Alternativ können in der Speichereinheit als konfigurationsspezifische Daten auch direkt Konfigurationsdaten abgespeichert sein.

Besonders vorteilhaft sind erste Konfigurationsdaten zur Konfiguration zumindest eines binärer Signalausganges des Prüfgeräts gespeichert. Das ermöglicht es, auf einfachste Weise eine grundlegende Funktionsprüfung der Steuereinheit durchzuführen, ohne auf externe Prüfsoftware angewiesen zu sein und ohne zeitaufwendig allfällige weitere Signalein- oder Signalausgänge konfigurieren zu müssen. Damit kann rasch eine Aussage getroffen werden, ob die Steuereinheit überhaupt funktioniert.

Indem erste Konfigurationsdaten zur Konfiguration zumindest eines binärer Signaleinganges des Prüfgeräts gespeichert werden, kann der Umfang der grundlegenden Funktionsprüfung erweitert werden, indem damit auch das Zusammenspiel zwischen Steuereinheit und der nachgebildeten Schaltvorrichtung in Form des Prüfgeräts, also das gegenseitige Reagieren aufeinander, geprüft werden kann. Für eine volle Funktionsprüfung sind alle binären Signaleingänge und binären Signalausgänge des Prüfgeräts zu konfigurieren, das umfasst damit alle benötigten Trip-, Close- und Schalterhilfskontakt-Leitungen, die an der realen Schaltvorrichtung 5 vorgesehen sind.

Für eine weiterführende Parameterprüfung kann vorgesehen sein, zweite Konfigurationsdaten zur Konfiguration zumindest eines analogen Signalausganges des Prüfgeräts zu speichern. Das ermöglicht es auch Ströme und Spannungen der Schaltanlage in die Prüfung einzubinden, womit sehr umfangreiche Prüfungen möglich sind.

Die gegenständliche Erfindung wird nachfolgend unter Bezugnahme auf die Figuren 1 bis 5 näher erläutert, die beispielhaft, schematisch und nicht einschränkend vorteilhafte Ausgestaltungen der Erfindung zeigen. Dabei zeigt
Fig.1 eine bekannte Anordnung einer Schaltanlage,
Fig.2 eine Anordnung zum Prüfen der Steuereinheit der Schaltanlage,
Fig.3 mögliche Anordnungen einer Speichereinheit zum Speichern konfigurationsspezifische Daten am Adapterkabel,
Fig.4 eine konfigurierte Prüfanordnung mit Steuereinheit und Prüfgerät und
Fig.5 ein beispielhafter Ablauf einer Prüfung der Schaltanlage.

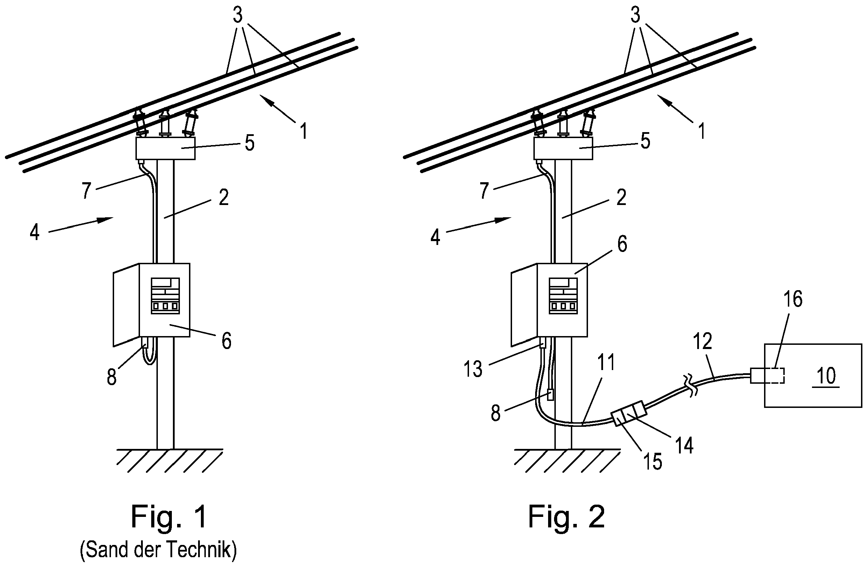

In Fig.1 ist ein Teil eines elektrischen Versorgungsnetzes 1 dargestellt, im gezeigten Ausführungsbeispiel eine 3-phasige Freileitung, deren Leitungen 3 in herkömmlicher Weise zwischen Masten 2 gespannt sind. Am Mast 2 ist als Sicherheitseinrichtung eine Schaltanlage 4 vorgesehen, die aus einer Schaltvorrichtung 5 und einer zugehörigen Steuereinheit 6 besteht. Die Schaltvorrichtung 5 ist beispielsweise ein Recloser oder ein Sectionalizer wie eingangs beschrieben und ist in der Lage durch eine von der Steuereinheit 6 ausgelöste Schalthandlung zumindest eine der Leitungen 3 zu trennen oder zu verbinden. Die Erfindung ist aber natürlich nicht auf die Anwendung in einem elektrischen Versorgungsnetz 1 in Form einer Freileitung beschränkt, sondern kann in jeder Anlage zur Übertragung oder Verteilung von elektrischer Energie mit Sicherheitseinrichtungen in Form einer Schaltanlage 4 mit einer Schaltvorrichtung 5 und einer zugehörigen Steuereinheit 6 verwendet werden.

Die Schaltvorrichtung 5 ist hierzu mit einer Steuerverbindung 7 und einem Stecker 8 am Ende der Steuerverbindung 7 mit der Steuereinheit 6 verbunden. Die Steuerverbindung 7 umfasst hierzu in der Regel eine Anzahl von Steuerleitungen für Steuereingangsgrößen und Steuerausgangsgrößen der Steuereinheit 6. Steuereingangsgrößen der Steuereinheit 6 sind beispielsweise Messgrößen der Anlage zur Übertragung oder Verteilung von elektrischer Energie, die von der Schaltvorrichtung 5, bzw. darin verbauten Messgeräten wie Stromwandlern, erfasst werden, insbesondere gemessene Ströme oder Spannungen, und der Steuereinheit 6 zur Auswertung übermittelt werden. Zu den Steuereingangsgrößen gehören aber typischer Weise auch Signale von eventuell vorhandenen Hilfskontakten der Schaltvorrichtung 5, die einen bestimmten Schaltzustand (offen, geschlossen) signalisieren. Steuerausgangsgrößen der Steuereinheit 6 sind Signale, die von der Steuereinheit 6, insbesondere in Reaktion auf die Steuereingangsgrößen, erzeugt werden und mit denen die Funktion der Schaltvorrichtung 5 gesteuert wird, beispielsweise eine Schalthandlung ausgelöst wird.

Zum Prüfen der Schaltanlage 4 wird die Steuerverbindung 7 zwischen Schaltvorrichtung 5 und Steuereinheit 6 getrennt, indem der Stecker 8 der Steuerverbindung 7 gezogen wird, wie in Fig.2 dargestellt. Es wäre auch möglich, dass die Schaltvorrichtung 5 vor der Prüfung gar nicht mit der Steuereinheit 6 verbunden ist, beispielsweise bei Erstinbetriebnahme. Dann würde das Trennen der Steuerverbindung 7 entfallen. Das ist recht häufig der Fall, da die Steuereinheiten 6 oft vor Installation parametriert und anschließend mit dem Prüfgerät 10 auf Funktion getestet werden, bevor diese "ins Feld" gebracht und installiert werden.

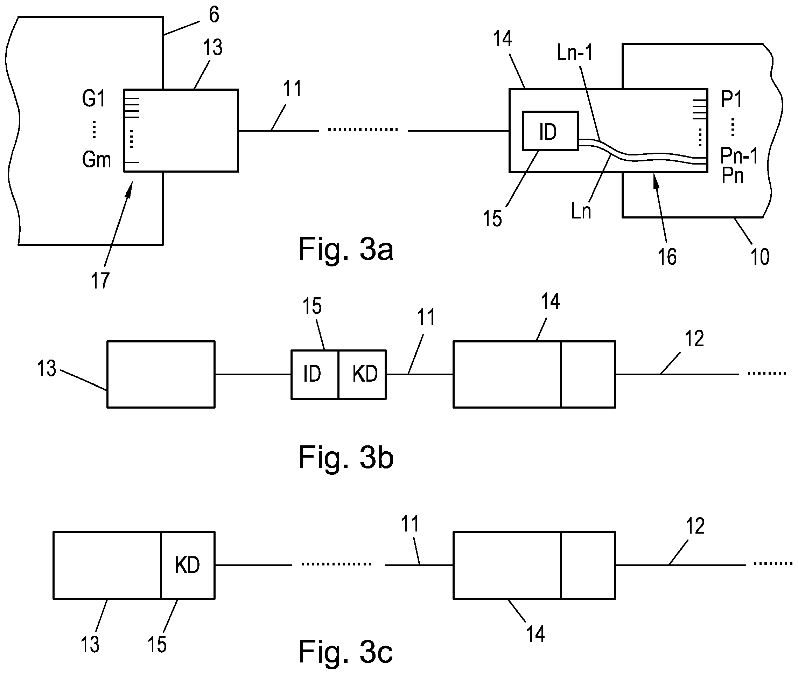

Die Steuereinheit 6 wird zur Prüfung mit einem Adapterkabel 11 mit einem Prüfgerät 10 verbunden, das die Schaltvorrichtung 5 simuliert, um die ordnungsgemäße Funktion und Parametrierung der Steuereinheit 6 der Schaltanlage 4 prüfen zu können. Das Adapterkabel 11 wird mit einem ersten Stecker 13 über eine elektrische Schnittstelle 17 mit der Steuereinheit 6 verbunden. Der Stecker 13 entspricht dabei in seiner Pinanzahl, Pinbelegung und Geometrie den Anforderungen der Steuereinheit 6. Gängige Steuereinheiten 6 variieren hier zwischen 10 und 42 Pins Gm (Fig.3a) mit verschiedenster Pinbelegung. Demnach gibt es für die verschiedenen Steuereinheiten 6 (Hersteller, Typ, Schnittstelle, Baujahr, etc.) entsprechende Adapterkabel 11. Mit einem zweiten Stecker 14 am anderen Ende des Adapterkabels 11 wird das Adapterkabel 11 mit dem Prüfgerät 10 verbunden. Hierzu kann am Prüfgerät 10 eine einheitliche elektrische Schnittstelle 16 mit einer definierten Anzahl Pins Pn (Fig.3a) und einer definierten Pinbelegung vorgesehen sein. Die Pins Gm der Verbindung zwischen Steuereinheit 6 und Adapterkabel 11 werden damit auf die Pins Pn mit einer einheitlichen Pinbelegung der Schnittstelle 16 des Prüfgeräts 10 umgelegt, d.h. die Pins Gm der Schnittstelle 17 an der Steuereinheit 6 werden bestimmten Pins Pn am Prüfgerät 10 zugeordnet. Damit können etwaige Verbindungsfehler von vornherein vermieden werden, da durch das Stecken der Stecker 13, 14 des Adapterkabels 11 für eine korrekte Zuordnung gesorgt ist.

Um Kosten zu sparen, kann auch ein langes Interfacekabel 12, z.B. mit einer Länge von einigen Metern, vorgesehen sein, das mit einem Ende in das Prüfgerät 10 gesteckt ist und mit dem anderen Ende über eine Steckverbindung mit dem Adapterkabel 11 verbunden ist, wie in Fig.2 dargestellt. Das Interfacekabel 12 kann aber auch entfallen. Durch das Interfacekabel 12 wird die Schnittstelle 16 des Prüfgeräts 10 näher zur Steuereinheit 6 gebracht, wodurch die notwendige Länge der Adapterkabel 11 für die verschiedenen Steuereinheiten 6 reduziert werden kann, vorzugsweise auf eine Länge unterhalb eines Meters. Damit müssen nur kurze Adapterkabel 11 in verschiedener Ausprägung und nur ein einziges Interfacekabel 12, gegebenenfalls verschieden lange Interfacekabel 12, vorrätig gehalten werden, was die gesamte Logistik der Prüfung erleichtert.

Das Prüfgerät 10 dient somit dazu, die Schaltvorrichtung 5 nachzubilden bzw. zu simulieren. Dazu hat das Prüfgerät 10 eine Reihe von Signaleingängen und Signalausgängen. Über die Signaleingänge empfängt das Prüfgerät Steuerausgangsgrößen der Steuereinheit 6 und über die Signalausgänge werden Steuereingangsgrößen der Steuereinheit 6 gesetzt.

Eine Schaltvorrichtung 5 hat in der Regel binäre Signaleingänge und binäre Signalausgänge. Über binäre Signaleingänge werden typischerweise Schalthandlungen ausgelöst, z.B. von der Steuereinheit 6. Hier kann es separate Signaleingänge für ein Trip-Signal (also Öffnen der Schaltvorrichtung 5) und für ein Close-Signal (also Schließen der Schaltvorrichtung 5) geben. Es kann aber auch nur ein binärer Signaleingang für Trip und Close verwendet werden. Ebenfalls gibt es Schaltvorrichtungen 5, bei denen für alle vorhandenen Phasen nur ein Eingang für Trip/Close verwendet wird, und solche, bei denen für jede einzelne Phase der Schaltvorrichtung 5 jeweils ein Eingang für Trip/Close verwendet wird. Außerdem hat eine Schaltvorrichtung 5 in der Regel Schalterhilfskontakte, um den Schaltzustand der Schaltvorrichtung 5 über einen binären Signalausgang zu signalisieren. Auch hier können wiederum separate Schalterhilfskontakte für Offen und Geschlossen vorgesehen sein, ebenso wieder für alle Phasen gemeinsam oder für jede Phase einzeln. Daneben hat eine Schaltvorrichtung 5 auch oftmals analoge Signalausgänge, an denen Messwerte von Strom oder Spannung übertragen werden. Das Prüfgerät 10 zur Nachbildung der Schaltvorrichtung 5 muss daher konfiguriert werden, um die in der Schaltvorrichtung 5 vorhandenen Signaleingänge und Signalausgänge nachbilden zu können. Wobei für eine Prüfung nicht unbedingt alle Signaleingänge oder Signalausgänge benötigt werden und daher auch nicht unbedingt alle zu konfigurieren sind.

Oftmals werden in Schaltvorrichtung 5 Schalthandlungen mit unterschiedlich gepolten Signalen angezeigt, also z.B. +1 für Close und -1 für Trip, wobei dabei 0 keiner Schalthandlung entspricht. Auch das wird im Sinne der gegenständlichen Erfindung als binärer Signaleingang aufgefasst.

Damit das Prüfgerät 10 die Schaltvorrichtung 5 für das Prüfen der Schaltanlage 4 nachbilden kann, benötigt es Konfigurationsdaten KD, um das Prüfgerät 10 entsprechend einstellen zu können. Die Konfigurationsdaten KD können Information der elektrischen Schnittstelle 17 der Steuereinheit 6 und/oder Information der Funktion der Schaltvorrichtung 5 umfassen. Für die elektrische Schnittstelle 17 können Daten wie die Pinbelegung der Pins G1 ... Gm am Stecker 13, die Spannungspegel verschiedener Pins G1 ... Gm des Steckers 13, eine Information zu analogen oder binären Pins, die Zuordnung der Pins G1 ... Gm des Steckers 13 als Steuereingangsgröße oder Steuerausgangsgröße, die Zuordnung der Pins G1 ... Gm der elektrischen Schnittstelle 17 der Steuereinheit 6 zu Pins P1 ... Pn der Schnittstelle 16 des Prüfgeräts 10, etc. gespeichert sein. Als Konfigurationsdaten KD die Funktion der Schaltvorrichtung 5 betreffend können die Schaltzeiten oder Schaltverzögerungen der Schalter der Schaltvorrichtung 5, Nominalwerte der Schaltvorrichtung 5, wie beispielsweise das Übersetzungsverhältnis der Strom- und Spannungswandler, Art der Wandler (beispielsweise konventionelle Stromwandler oder Rogowski-Wandler) und damit verbunden die Konfiguration des Prüfgeräts 10 wie beispielsweise die richtige Auswahl der Analogausgänge AE und Setzen eines Maximalwerts zum Schutz der Steuereinheit 6, usw., gespeichert sein.

Am Adapterkabel 11, das wie oben ausgeführt steuereinheitenspezifisch ausgeführt sein muss, ist eine Speichereinheit 15 angeordnet. Die Speichereinheit 15 kann dabei an unterschiedlichen Stellen des Adapterkabels 11 vorgesehen sein, wie in den Figuren 3a bis 3c angedeutet wird. Beispielsweise ist die Speichereinheit 15 im Stecker 14 zur Verbindung des Adapterkabels 11 mit dem Prüfgerät 10 (Fig.3a) oder dem Interfacekabel 12 (Fig.2) vorgesehen. Die Speichereinheit 15 kann auch an einer beliebigen Stelle des Adapterkabels 11 zwischen den beiden begrenzenden Steckern 13, 14 angeordnet sein (Fig.3b) und kann auch am Stecker 13 zur Verbindung des Adapterkabels 11 mit der Steuereinheit 6 angeordnet sein.

Die Speichereinheit 15 kann hierbei beliebig ausgeführt sein und muss lediglich geeignet sein, Information zu speichern. Im einfachsten Fall könnte die Speichereinheit 15 als passives elektrisches Bauelement, z.B. als Widerstand, ausgeführt sein. Wird an das elektrische Bauelement eine definierte Abfragespannung angelegt, dann antwortet diese mit einem elektrischen Strom in Abhängigkeit vom Bauelement. Damit können z.B. verschiedene Adapterkabel 11 einfach identifiziert werden. Die Speichereinheit 15 kann aber auch als elektronischer Speicherbaustein ausgeführt sein, der die Information digital speichert.

Die Speichereinheit 15 muss lediglich vom Prüfgerät 10 auslesbar sein. Dafür können eine Anzahl von Pins Pn-1, Pn der Schnittstelle 16 zum Prüfgerät 10 für das Auslesen der Speichereinheit 15 vorgesehen sein, wie in Fig.3a angedeutet. Dafür können auch entsprechende Leitungen Ln-1, Ln (auch im Adapterkabel 11) vorgesehen sein, die die Pins Pn-1, Pn mit der Speichereinheit 15 verbinden. Zum Auslesen können aber auch Leitungen des Adapterkabels 11 verwendet werden, die an sich zum Prüfen der Steuereinheit 6 benötigt werden, beispielsweise, wenn die Steuereinheit 6 vorher in einen Auslesemodus geschaltet wird. Zum Auslesen der Speichereinheit 15 kann ein beliebiges Datenübertragungsverfahren, gegebenenfalls mit einem beliebigen Datenübertragungsprotokoll, implementiert sein.

In der Speichereinheit 15 sind konfigurationsspezifische Daten, also Daten die die Konfiguration und Funktion der Schaltanlage 4 beschreiben gespeichert. Als konfigurationsspezifische Daten können oben genannte Konfigurationsdaten KD (Fig.3c), eine eindeutige Identifikation ID des Adapterkabels 11 (Fig.3a) oder eine Mischung davon (Fig.3b) gespeichert sein.

Sind in der Speichereinheit 15 als konfigurationsspezifische Daten direkt Konfigurationsdaten KD gespeichert, liest das Prüfgerät 10 die Konfigurationsdaten KD aus und konfiguriert sich mit diesen Konfigurationsdaten KD selbsttätig.

Ist in der Speichereinheit 15 eine eindeutige Identifikation ID des Adapterkabels 11 gespeichert, liest das Prüfgerät 10 diese Identifikation ID ein. Für eine bestimmte Schaltvorrichtung 5 kann es zugehörige Steuereinheiten 6 verschiedener Hersteller geben, die aber zwangsweise dieselbe elektrische Schnittstelle für die Schaltvorrichtung 5 besitzen müssen. Damit kann für diese Steuereinheiten 15 verschiedener Hersteller auch der gleiche Typ Adapterkabel 11 verwendet werden. Gewisse für die Prüfung benötigte Konfigurationsdaten KD lassen sich unter Umständen schon teilweise oder sogar zu Gänze aus dem Kabeltyp des Adapterkabels 11 ableiten, der anhand der eindeutigen Identifikation ID festgelegt ist, ohne das genaue Fabrikat der Steuereinheit 6 kennen zu müssen. Beispielsweise kommt es bei der Zuweisung der binären Signaleingänge und binären Signalausgänge am Prüfgerät 10 und deren Timingeinstellungen nicht auf den Typ der Steuereinheit 6 an, sondern nur auf die zu simulierende Schaltvorrichtung 5. Damit lassen sich aus der Kenntnis des Typs des Adaperkabels 11 schon gewissen Grundeinstellungen am Prüfgerät 10 vornehmen. Die Identifikation ID des Adapterkabels 11 kann daher schon ausreichen, um das Prüfgerät 10 für grundlegende Funktionsprüfungen einzurichten.

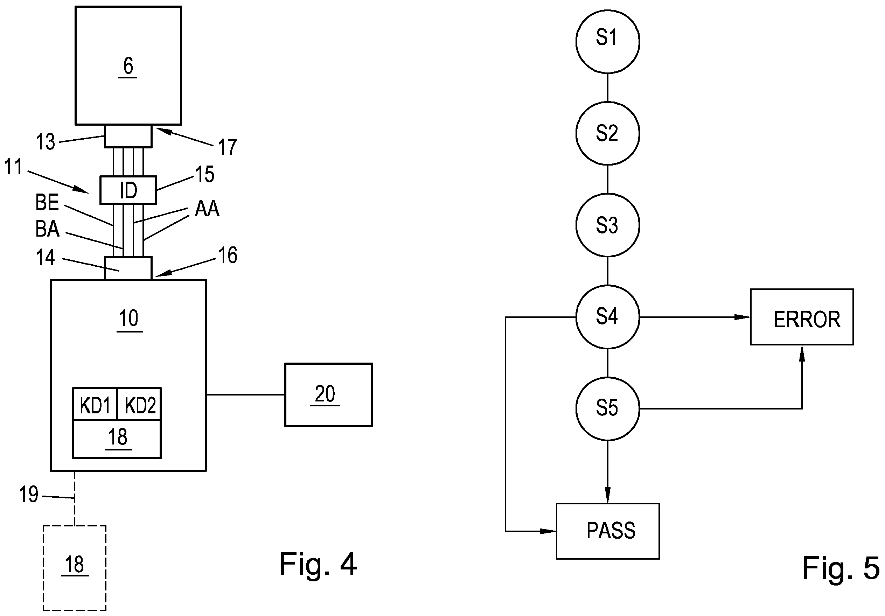

Hierzu können im Prüfgerät 10 in einem Konfigurationsdatenspeicher 18 notwendige Konfigurationsdaten KD einer Identifikation ID eines Adapterkabels 11 zugeordnet gespeichert sein, die dann nach Auslesen der Identifikation ID aus der Speichereinheit 15 verwendet werden, um das Prüfgerät 10 für die Prüfung der Schaltanlage 4 einzurichten. Die notwendigen, einer Identifikation ID zugeordneten Konfigurationsdaten KD müssen aber nicht unbedingt direkt im Prüfgerät 10 gespeichert sein, sondern können auch in einem externen Konfigurationsdatenspeicher 18 der Identifikation ID zugeordnet abgelegt sein (wie in Fig.4 angedeutet). Hierzu kann sich das Prüfgerät 10 über eine Datenverbindung 19, wie z.B. ein LAN, WLAN, Bluetooth, etc., mit dem Konfigurationsdatenspeicher 18 verbinden und die benötigten Daten auslesen, um sich damit zu konfigurieren.

Selbstverständlich ist auch eine beliebige Mischung dieser beiden Methoden denkbar, also dass gewisse Konfigurationsdaten KD direkt in der Speichereinheit 15 gespeichert sind und andere Konfigurationsdaten KD über die gespeicherte eindeutige Identifikation ID abgefragt werden.

Der Ablauf einer Prüfung einer Schaltanlage 4 mit einer Schaltvorrichtung 5 und einer zugehörigen Steuereinheit 6 kann unter Bezugnahme auf die Fig.4 und 5 beispielswiese wie folgt ablaufen, wobei schon davon ausgegangen wird, dass das Prüfgerät 10 wie oben beschrieben mit einem Adapterkabel 11 mit der Steuereinheit 6 verbunden ist (Schritt S1).

In der Speichereinheit 15 des Adapterkabels 11 ist eine Identifikation ID hinterlegt, welche den Typ des Adapterkabels 11 eindeutig identifiziert. Im Prüfgerät 10 sind die Konfigurationsdaten KD für alle verfügbaren Adapterkabel 11 und die Zuordnung zu den eindeutigen Identifikationen ID im Konfigurationsdatenspeicher 18 gespeichert (z.B. welche Pins an der elektrischen Schnittstelle 16, 17 verwendet werden und wie diese zugeordnet sind, Spannungspegel, Leistungschalterhilfskontakt-Zeiten, etc.). Wird das Prüfgerät 10 eingeschaltet, liest das Prüfgerät 10 automatisch die Identifikation ID aus der Speichereinheit 15 aus und es wird beispielsweise im Prüfgerät 10 ein Schaltvorrichtungssimulator, hier z.B. ein Leistungsschaltersimulator bei einem Leistungsschalter als Schaltvorrichtung 5, gestartet und dafür anhand von zur Identifikation ID gespeicherten ersten Konfigurationsdaten KD1 die binären Signaleingänge BE (gegebenenfalls auch nur ein Binäreingang) und/oder die binären Signalausgänge BA (gegebenenfalls auch nur ein Binärausgang) des Prüfgeräts 10 entsprechend automatisch konfiguriert (Schritt S2). Das umfasst beispielsweise die Zuordnung der vorgegebenen Pins Pn für die binären Signalein- und Signalusgänge BE, BA an der Schnittstelle 16 am Prüfgerät 10 zu bestimmten Pins Gm der Schnittstelle 17 an der Steuereinheit 6, sowie die Definition des logischen Gehalts einer binären 0 oder 1, also z.B. 0=kein Trip, 1=Trip bzw. 0=kein Close, 1=Close des Binäreingangs, oder 0=Offen, 1=Geschlossen des Binärausgangs, aber auch die Spannungspegel der binären Signalein- und Signalausgänge BE, BA. Zusätzlich kann auch das Timing der binären Signaleingänge BE und/oder binären Signalausgänge BA durch die gespeicherte erste Konfigurationsdaten KD1 festgelegt sein, z.B. wie lange ein Trip-Befehl an einem binären Signaleingänge BE des Prüfgeräts 10 anliegen muss oder wie lange die Schaltvorrichtung 5 zum Schalten benötigt, was an einem binären Signalausgänge BA signalisiert wird.

Anstelle einer Identifikation ID können diese grundlegenden ersten Konfigurationsdaten KD1 natürlich auch direkt in der Speichereinheit 15 abgelegt sein und von dort direkt vom Prüfgerät 10 ausgelesen werden.

Mit dieser Grundkonfiguration kann für die Steuereinheit 6 schon eine grundlegende Funktionsprüfung durchgeführt werden (Schritt S3), um zu prüfen, ob die Steuereinheit 6 überhaupt richtig auf Ereignisse, die vom Prüfgerät 10 signalisiert werden, reagiert. Hier sind beispielsweise die folgenden Prüfungen vorstellbar:
Die allermeisten Schaltvorrichtungen 5 besitzen manuell betätigbare Schaltgriffe, die es ermöglichen die Schaltvorrichtung 5 mechanisch, von Hand zu schalten, also zu öffnen oder zu schließen. Die jeweilige Schaltstellung wird dabei über die Schalterhilfskontakte an zugeordneten Binärausgängen der Schaltvorrichtung 5 an die Steuereinheit 6 signalisiert. Das kann nun in der grundlegenden Funktionsprüfung mit dem Schaltvorrichtungssimulator im Prüfgerät 10 nachgebildet werden. Am Prüfgerät 10 können hierzu TRIP- und CLOSE-Taster vorgesehen sein, mittel der auf den binären Signalausgängen BA eine bestimmte Schaltstellung signalisiert werden kann. Dabei können mit einem Taster alle Phasen gleichzeitig geschaltet werden, oder es können auch einzelne Taster für die verschiedenen Phasen vorhanden sein. Es reicht hierfür folglich aus, wenn zumindest ein binärer Signalausgang BA des Prüfgeräts 10 konfiguriert wird.

Je nach Art und Typ der Schaltvorrichtungen 5 kann es natürlich auch notwendig sein, für eine grundlegende Funktionsprüfung mehrere binäre Signalausgänge BA des Prüfgeräts 10 zu konfigurieren. Für die Funktionsprüfung muss in jedem Fall ein gültiges Signal auf allen binären Signalausgängen BA, deren Konfiguration von der Steuereinheit 6 vorgegeben sind, anliegen. Hat die Schaltvorrichtung 5 beispielsweise einen Schalterhilfskontakt für die Trip-Anzeige und einen Schalterhilfskontakt für die Close-Anzeige, so müssen die zugehörigen binären Signalausgänge BA immer gegengleich sein, also ein Offen bei Trip würde ein Geschlossen bei Close bedingen. Es gibt aber auch Schaltvorrichtungen 5, die nur einen Schalterhilfskontakt haben. In diesem Fall wäre ein binärer Signalausgang BA ausreichend. Geht man aber von einer 3-phasigen Schaltvorrichtung 5 aus, welche 1-phasig betätigt werden kann (also eine Schalthandlung schaltet zwangsweise alle Phasen gleichzeitig), so reicht ein einzelner binärer Signalausgang BA nicht aus, denn auch die anderen Phasen müssen einen gültigen Status haben, der entsprechend signalisiert werden muss.

Für die grundlegende Funktionsprüfung könnten aber auch an der Steuereinheit 6 vorhandene Schalter oder Taster zum manuellen Auslösen einer Schalthandlung genutzt werden. Die von der Steuereinheit 6 gewünschte Schalthandlung wird dabei dem Prüfgerät 10 auf einem binären Signaleingang BE signalisiert, das daraufhin die zugeordnete Phase (oder gegebenenfalls alle Phasen) schaltet. Die durchgeführte Schalthandlung wird der Steuereinheit 6 über einen binären Signalausgang BAdes Prüfgeräts 10, gegebenenfalls auch entsprechend dem hinterlegten Timings für die Schalterhilfskontakte, signalisiert.

Für eine derartige grundlegende Funktionsprüfung ist man daher vollkommen unabhängig von einer externen Prüfsoftware und von der Konfiguration von anderen, insbesondere analogen, Signalein- und/oder Signalausgängen. Schlägt diese grundlegende Funktionsprüfung fehl, erübrigt es sich, weitere Prüfungen durchzuführen und die Prüfung kann mit einer Fehlermeldung abgebrochen werden.

Für eine über die grundlegende Funktionsprüfung hinausgehende Prüfung, sofern eine solche erwünscht ist, muss das Prüfgerät 10 gegebenenfalls mittels weiterer zweiter Konfigurationsdaten KD2 parametriert werden, um die Schaltvorrichtung 5 in ihrer ganzen Funktionalität nachbilden zu können (Schritt S5). Dabei muss das Prüfgerät 10 insbesondere so eingerichtet werden, dass allfällige weitere analoge Signalausgänge AA des Prüfgeräts 10 richtig parametriert sind. Über analoge Signalausgänge AA werden beispielsweise Spannungen oder Ströme an die Steuereinheit 6 übertragen, die an der realen Schaltvorrichtung 5 gemessen werden und die folglich für die Prüfung vom Prüfgerät 10 nachzubilden sind. Dazu können im Prüfgerät 10 Strom- und/oder Spannungsverstärker verbaut sein, die so parametriert werden müssen (beispielsweise welcher Verstärker verwendet wird, Spannungs- / Strombereich, Nominalwerte, etc.), um die für die Nachbildung der Schaltvorrichtung 5 benötigten Ströme und Spannungen liefern zu können. Auch in der Schaltvorrichtung 5 verbaute Messsensoren, wie z.B. Stromwandler oder Spannungssensoren, können im Prüfgerät 10 nachgebildet werden, was ebenfalls eine Parametrierung notwendig machen kann (beispielsweise das Wandlungsverhältnis eines Stromwandlers, der Messbereich eines Spannungssensors, etc.).

Die hierfür notwendigen zweiten Konfigurationsdaten KD2 können wiederum über die eindeutige Identifikation ID aus einem Konfigurationsdatenspeicher 18 ausgelesen werden oder können direkt aus der Speichereinheit 15 ausgelesen werden, sofern diese dort gespeichert sind.

Je nach Funktionsumfang der Steuereinheit 6 können mehr oder weniger analoge Signaleingänge AE und/oder analoge Signalausgänge AA zu parametrieren sein. Daher kann es für diese Art der Prüfung notwendig sein, die konkret verwendete Steuereinheit 6 auszuwählen, falls es zu einer bestimmten Identifikation ID mehrere Steuereinheiten 6 geben kann. Diese Auswahl kann dem Benutzer des Prüfgeräts 10 angeboten werden.

Mittels der analogen Signalausgänge AA können komplexerer Prüfungen der Steuereinheit 6 durchgeführt werden (Schritt S5), die auch Strom- und oder Spannungswerte der einzelnen Phasen der Schaltvorrichtungen 5 umfassen. Für die Durchführung solcher weitergehenden Prüfungen ist eine spezielle Prüfsoftware notwendig, die entweder am Prüfgerät 10 oder auf einer externen Steuereinheit 20 (z.B. ein PC, Laptop, Tablet, usw.) installiert sein kann. Dabei können auch verschiedenste Prüfpläne aufgerufen und abgearbeitet werden, auch automatisch, deren Ergebnis (Fehler ERROR oder erfolgreich absolviert PASS) auch mitprotokolliert werden kann.

Will man nun beispielsweise Strom- und Spannungseingänge der Steuereinheit 6 prüfen, kann der Benutzer die externe Steuereinheit 20 verwenden und er kann sich dann entweder über eine kabellose oder kabelgebundene Verbindung mit dem Prüfgerät 10 verbinden. Ist die Verbindung hergestellt, teilt das Prüfgerät 10 der Prüfsoftware mit, welches Adapterkabel 11 (Identifikation ID) angeschlossen ist. In der Prüfsoftware wird dann die Identifikation ID des Adapterkabel 11 verwendet und über eine in der Prüfsoftware hinterlegte Tabelle automatisch die zugehörige Steuereinheit 6 ausgewählt oder dem Benutzer eine Liste möglicher Steuereinheiten 6 zur Auswahl angeboten. Die Steuereinheiten 6 besitzen meist eine grundlegende Konfiguration, die dann bereits zum Vorkonfigurieren des Prüfgeräts 10 geladen werden kann. Gegebenenfalls wird die Konfiguration durch den Benutzer ergänzt bzw. vervollständigt.

Der Grundgedanke des erfindungsgemäßen Verfahrens ist also, dass ein Benutzer unabhängig von zusätzlicher Prüfsoftware zumindest schon grundlegende Funktionsprüfungen an der Steuereinheit 6 durchführen kann, ohne ein Prüfgerät 10 vollständig konfigurieren oder parametrieren zu müssen. Das ermöglicht die rasche Prüfung von grundlegenden Funktionen, bevor aufwendig eine komplette Konfiguration durchgeführt wird. Für zusätzliche Prüfungen, beispielsweise bei Erstinbetriebnahme oder bei einer kompletten Routineprüfung, wird der Prüfprozess stark vereinfacht, da die Steuereinheit 6 anhand des identifizierten Adapterkabels 11 in der Prüfsoftware automatisch ausgewählt und das Prüfgerät 10 zumindest vorkonfiguriert wird. Wenn ein Adapterkabel 11 mehreren Steuereinheiten 6 zugeordnet ist, kann die Auswahl der richtigen Steuereinheit 6 für den Benutzer zumindest erheblich reduziert und damit vereinfacht werden.

## Patentansprüche

1. Prüfgerät (10) und damit verbundenes Adapterkabel (11) für eine Steuereinheit (6) einer Schaltvorrichtung (5) einer Schaltanlage (4), wobei das Prüfgerät (10) eine Anzahl von Signaleingängen (BE) und eine Anzahl von Signalausgängen (BA, AA) aufweist und das Prüfgerät (10) über das Adapterkabel (11) mit der Steuereinheit (6) verbindbar ist und das Prüfgerät (10) für die Prüfung die Schaltvorrichtung (5) nachbildet, **dadurch gekennzeichnet, dass** am Adapterkabel (11) eine Speichereinheit (15) vorgesehen ist, auf der konfigurationsspezifische Daten gespeichert und vom Prüfgerät (10) auslesbar sind **und dass** das Prüfgerät (10) ausgebildet ist, seine für eine Durchführung einer Prüfung benötigten Signaleingänge (BE) und Signalausgänge (BA, AA) gemäß den konfigurationsspezifischen Daten selbsttätig zu konfigurieren.

2. Prüfgerät (10) und Adapterkabel (11) nach Anspruch 1, **dadurch gekennzeichnet, dass** als konfigurationsspezifische Daten eine eindeutige Identifikation (ID) des Adapterkabels (11) gespeichert ist und in der Prüfanordnung ein Konfigurationsdatenspeicher (18) vorgesehen ist, in dem Konfigurationsdaten (KD) zur Konfiguration von benötigten Signaleingänge(BE) und Signalausgänge (BA, AA) gespeichert sind.

3. Prüfgerät (10) und Adapterkabel (11) nach Anspruch 1 oder 2, **dadurch gekennzeichnet, dass** als konfigurationsspezifische Daten Konfigurationsdaten (KD) zur Konfiguration von benötigten Signaleingänge (BE) und Signalausgänge (BA, AA) gespeichert sind.

4. Prüfgerät (10) und Adapterkabel (11) nach Anspruch 2 oder 3, **dadurch gekennzeichnet, dass** erste Konfigurationsdaten (KD1) zur Konfiguration zumindest eines binärer Signalausganges (BA) des Prüfgeräts (10) gespeichert sind.

5. Prüfgerät (10) und Adapterkabel (11) nach Anspruch 2 oder 3, **dadurch gekennzeichnet, dass** erste Konfigurationsdaten (KD1) zur Konfiguration zumindest eines binärer Signaleinganges (BE) des Prüfgeräts (10) gespeichert sind.

6. Prüfgerät (10) und Adapterkabel (11) nach Anspruch 2 oder 3, **dadurch gekennzeichnet, dass** zweite Konfigurationsdaten (KD2) zur Konfiguration zumindest eines analogen Signalausganges (AA) des Prüfgeräts (10) gespeichert sind.

7. Verwendung des Prüfgeräts (10) und Adapterkabels (11) nach einem der Ansprüche 1 bis 6 in einer Prüfanordnung zum Prüfen einer Steuereinheit (6) einer Schaltvorrichtung (5) einer Schaltanlage (4), wobei das Adapterkabel (11) mit der Steuereinheit (6) verbunden ist.

8. Verfahren zum Vorbereiten einer Prüfung einer Steuereinheit (6) einer Schaltvorrichtung (5) einer Schaltanlage (4), wobei ein Prüfgerät (10) mit einer Anzahl von Signaleingängen (BE) und einer Anzahl von Signalausgängen (BA, AA) mit einem Adapterkabel (11) mit der Steuereinheit (6) verbunden wird und das Prüfgerät (10) für die Prüfung die Schaltvorrichtung (5) nachbildet, **dadurch gekennzeichnet, dass** das Prüfgerät (10) aus einer Speichereinheit (15) am Adapterkabel (11) konfigurationsspezifische Daten ausliest und das Prüfgerät (10) damit seine für die Durchführung der Prüfung benötigten Signaleingänge (BE) und Signalausgänge (BA, AA) konfiguriert.

9. Verfahren nach Anspruch 8, **dadurch gekennzeichnet, dass** das Prüfgerät (10) als konfigurationsspezifische Daten aus der Speichereinheit (15) eine eindeutige Identifikation (ID) des Adapterkabels (11) ausliest und damit aus einem Konfigurationsdatenspeicher (18) Konfigurationsdaten (KD) zur Konfiguration von benötigten Signaleingänge (BE) und Signalausgänge (BA, AA) einliest.

10. Verfahren nach Anspruch 8 oder 9, **dadurch gekennzeichnet, dass** das Prüfgerät (10) als konfigurationsspezifische Daten aus der Speichereinheit (15) Konfigurationsdaten (KD) zur Konfiguration von benötigten Signaleingänge (BE) und Signalausgänge (BA, AA) einliest.

11. Verfahren nach Anspruch 9 oder 10, **dadurch gekennzeichnet, dass** die Konfigurationsdaten (KD) erste Konfigurationsdaten (KD1) umfassen, mit denen zumindest ein binärer Signalausgang (BA) des Prüfgeräts (10) konfiguriert wird.

12. Verfahren nach Anspruch 9 oder 10, **dadurch gekennzeichnet, dass** die Konfigurationsdaten (KD) erste Konfigurationsdaten (KD1) umfassen, mit denen zumindest ein binärer Signaleingang (BE) des Prüfgeräts (10) konfiguriert wird.

13. Verfahren nach Anspruch 9 oder 10, **dadurch gekennzeichnet, dass** die Konfigurationsdaten (KD) zweite Konfigurationsdaten (KD2) umfassen, mit denen zumindest ein analoger Signalausgang (AA) des Prüfgeräts (10) konfiguriert wird.

## Claims

1. Test device (10) and connected adapter cable (11) therewith for a control unit (6) of a switching device (5) of a substation (4), wherein the test device (10) has a number of signal inputs (BE) and a number of signal outputs (BA, AA) and the test device (10) is connectable to the control device (6) via the adapter cable (11) and simulates the test device (10) for testing switching device (5), **characterized in that** a storage unit (15) is provided at the adapter cable (11), on which configuration-specific data can be stored and read by the test device (10) **and that** the test device (10) is designed to automatically configure its signal inputs (BE) and signal outputs (BA,AA) necessary to perform a test according to the configuration-specific data.

2. Test device (10) and adapter cable (11) according to the claim 1, **characterized in that** a unique identification (ID) of the adapter cable (11) is stored as configuration-specific data and a configuration data storage (18) is provided in the test set-up, in which configuration data (KD) for configuring necessary signal inputs (BE) and signal outputs (BA, AA) are stored.

3. Test device (10) and adapter cable (11) according to claim 1 or 2, **characterized in that** configuration data (KD) for configuring necessary signal inputs (BE) and signal outputs (BA, AA) are stored as configuration-specific data.

4. Test device (10) and adapter cable (11) according to claim 2 or 3, **characterized in that** primary configuration data (KD1) are stored for configuring at least one binary signal output (BA) of the test device (10).

5. Test device (10) and adapter cable (11) according to claim 2 or 3, **characterized in that** primary configuration data (KD1) are stored for configuring at least one binary signal input (BE) of the test device (10).

6. Test device (10) and adapter cable (11) according to claim 2 or 3, **characterized in that** secondary configuration data (KD2) are stored for configuring at least one analog signal output (AA) of the test device (10).

7. Use of the test device (10) and adapter cable (11) according to either of claims 1 to 6 in a test set-up for testing a control unit (6) of a switching device (5) in a substation (4), wherein the adapter cable (11) is connected to the control unit (6).

8. Method to prepare a test of a control unit (6) of a switching device (5) in a substation (4), wherein a test device (10) having a number of signal inputs (BE) and a number of signal outputs (BA, AA) is connected to the control unit (6) using an adapter cable (11) and simulates the test device (10) for testing the switching device (5), **characterized in that** the testing device (10) reads configuration-specific data from a storage unit (15) on the adapter cable (11) and thereby the testing device (10) configures its signal inputs (BE) and signal outputs (BE, AA) necessary for performing the test.

9. Method according to claim 8, **characterized in that** the testing device (10) reads a unique identification (ID) of the adapter cable (11) as configuration-specific data from the storage unit (15) and thereby reads in configuration data (KD) for configuring the necessary signal inputs (BE) and signal outputs (BA, AA) from a configuration data storage (18).

10. Method according to claim 8 or 9, **characterized in that** the testing device (10) reads configuration data (KD) for configuring necessary signal inputs (BE) and signal outputs (BA, AA) from the storage unit (15) as configuration-specific data.

11. Method according to claim 9 or 10, **characterized in that** the configuration data (KD) include primary configuration data (KD1), using which at least one binary signal output (BA) of the test device (10) is configured.

12. Method according to claim 9 or 10, **characterized in that** the configuration data (KD) include primary configuration data (KD1), using which at least one binary signal input (BE) of the test device (10) is configured.

13. Method according to claim 9 or 10, **characterized in that** the configuration data (KD) include secondary configuration data (KD2), using which at least one analog signal output (AA) of the test device (10) is configured.

## Revendications

1. Dispositif de test (10) et câble adaptateur (11) relié à celui-ci destinés à une unité de commande (6) d'un appareil de commutation (5) d'un système de commutation (4), le dispositif de test (10) présentant un certain nombre d'entrées de signal (BE) et un certain nombre de sorties de signal (BA, AA) et le dispositif de test (10) pouvant être relié à l'unité de commande (6) par l'intermédiaire du câble adaptateur (11) et le dispositif de test (10) simulant l'appareil de commutation (5) pour le test, **caractérisés en ce qu'**une unité de stockage (15) est prévue sur le câble adaptateur (11), unité sur laquelle des données spécifiques à la configuration sont stockées et peuvent être lues par le dispositif de test (10), **et en ce que** le dispositif de test (10) est conçu pour configurer lui-même ses entrées de signal (BE) et ses sorties de signal (BA, AA) nécessaires à la réalisation d'un test selon les données spécifiques à la configuration.

2. Dispositif de test (10) et câble adaptateur (11) selon la revendication 1, **caractérisés en ce qu'**une identification unique (ID) du câble adaptateur (11) est stockée en tant que données spécifiques à la configuration, et **en ce qu'**un stockage de données de configuration (18) est prévu dans l'équipement de test, dans lequel les données de configuration (KD) permettant la configuration d'entrées de signal (BE) et de sorties de signal (BA, AA) nécessaires sont stockées.

3. Dispositif de test (10) et câble adaptateur (11) selon la revendication 1 ou 2, **caractérisés en ce que** les données de configuration (KD) permettant la configuration d'entrées de signal (BE) et de sorties de signal (BA, AA) nécessaires sont stockées en tant que données spécifiques à la configuration.

4. Dispositif de test (10) et câble adaptateur (11) selon la revendication 2 ou 3, **caractérisés en ce que des** premières données de configuration (KD1) permettant la configuration d'au moins une sortie de signal binaire (BA) du dispositif de test (10) sont stockées.

5. Dispositif de test (10) et câble adaptateur (11) selon la revendication 2 ou 3, **caractérisés en ce que des** premières données de configuration (KD1) permettant la configuration d'au moins une entrée de signal binaire (BE) du dispositif de test (10) sont stockées.

6. Dispositif de test (10) et câble adaptateur (11) selon la revendication 2 ou 3, **caractérisés en ce que des** secondes données de configuration (KD2) permettant la configuration d'au moins une sortie de signal analogue (AA) du dispositif de test (10) sont stockées.

7. Utilisation du dispositif de test (10) et du câble adaptateur (11) selon l'une des revendications 1 à 6 dans un équipement de test permettant le test d'une unité de commande (6) d'un appareil de commutation (5) d'un système de commutation (4), le câble adaptateur (11) étant relié à l'unité de commande (6).

8. Procédé de préparation d'un test d'une unité de commande (6) d'un appareil de commutation (5) d'un système de commutation (4), un dispositif de test (10) comportant un certain nombre d'entrées de signal (BE) et un certain nombre de sorties de signal (BA, AA) étant relié à l'unité de commande (6) au moyen d'un câble adaptateur (11), et le dispositif de test (10) simulant l'appareil de commutation (5) pour le test, **caractérisé en ce que** le dispositif de test (10) lit des données spécifiques à la configuration à partir d'une unité de stockage (15) sur le câble adaptateur (11), et **en ce que** le dispositif de test (10) configure ainsi ses entrées de signal (BE) et ses sorties de signal (BA, AA) nécessaires à la réalisation du test.

9. Procédé selon la revendication 8, **caractérisé en ce que** le dispositif de test (10) lit une identification unique (ID) du câble adaptateur (11) à partir de l'unité de stockage (15) en tant que données spécifiques à la configuration, et **en ce qu'**il saisit ainsi des données de configuration (KD) permettant la configuration d'entrées de signal (BE) et de sorties de signal (BA, AA) nécessaires à partir d'un stockage de données de configuration (18).

10. Procédé selon la revendication 8 ou 9, **caractérisé en ce que** le dispositif de test (10) saisit des données de configuration (KD) permettant la configuration d'entrées de signal (BE) et de sorties de signal (BA, AA) nécessaires en tant que données spécifiques à la configuration à partir de l'unité de stockage (15).

11. Procédé selon la revendication 9 ou 10, **caractérisé en ce que** les données de configuration (KD) comprennent des premières données de configuration (KD1) au moyen desquelles au moins une sortie de signal binaire (BA) du dispositif de test (10) est configurée.

12. Procédé selon la revendication 9 ou 10, **caractérisé en ce que** les données de configuration (KD) comprennent des premières données de configuration (KD1) au moyen desquelles au moins une entrée de signal binaire (BE) du dispositif de test (10) est configurée.

13. Procédé selon la revendication 9 ou 10, **caractérisé en ce que** les données de configuration (KD) comprennent des secondes données de configuration (KD2) au moyen desquelles au moins une sortie de signal analogue (AA) du dispositif de test (10) est configurée.
